(19) Europäisches Patentamt
European Patent Office
Office européen des brevets

(11) EP 2 270 252 B1

(12) EUROPEAN PATENT SPECIFICATION

(45) Date of publication and mention
of the grant of the patent:
**22.06.2016 Bulletin 2016/25**

(51) Int Cl.:
*C23C 14/34* (2006.01)          *B22F 1/00* (2006.01)
*B22F 3/14* (2006.01)           *B22F 3/15* (2006.01)
*G11B 7/243* (2013.01)          *G11B 7/26* (2006.01)
*C22C 12/00* (2006.01)          *C22C 28/00* (2006.01)

(21) Application number: **08873387.8**

(22) Date of filing: **09.12.2008**

(86) International application number:
**PCT/JP2008/072296**

(87) International publication number:
**WO 2009/116213 (24.09.2009 Gazette 2009/39)**

(54) **SINTERED TARGET AND METHOD FOR PRODUCTION OF SINTERED MATERIAL**

GESINTERTES TARGET UND VERFAHREN ZUR HERSTELLUNG VON GESINTERTEM MATERIAL

CIBLE FRITTÉ ET PROCÉDÉ DE FABRICATION D'UN MATÉRIAU FRITTÉ

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **17.03.2008 JP 2008067317
23.04.2008 JP 2008112652**

(43) Date of publication of application:
**05.01.2011 Bulletin 2011/01**

(73) Proprietor: **JX Nippon Mining & Metals
Corporation
Tokyo 100-8164 (JP)**

(72) Inventors:
• **FUKUYO, Hideaki**
**Kitaibaraki-shi,**
**Ibaraki 319-1535 (JP)**
• **YAHAGI, Masataka**
**Kitaibaraki-shi,**
**Ibaraki 319-1535 (JP)**

• **YAMAKOSHI, Yasuhiro**
**Kitaibaraki-shi,**
**Ibaraki 319-1535 (JP)**
• **TAKAHASHI, Hideyuki**
**Kitaibaraki-shi,**
**Ibaraki 319-1535 (JP)**

(74) Representative: **Hoarton, Lloyd Douglas Charles
et al
Forresters
Skygarden
Erika-Mann-Strasse 11
80636 München (DE)**

(56) References cited:
**EP-A1- 1 840 240          EP-A1- 1 903 122
WO-A1-2006/077692          WO-A1-2007/097396
WO-A2-2006/098781          WO-A2-2007/037796
JP-A- 2003 055 758          US-A1- 2007 099 332**

## Description

TECHNICAL FIELD

The present invention relates to a method of producing a sintered compact target capable of reducing minute defects within the sintered compact and having high deflecting strength, and containing a Vb group element (A) and a chalcogenide element (B) or containing the elements (A) and (B) and additionally a IVb group element (C) and/or an additive element (D).

BACKGROUND ART

In recent years, a thin film formed from a Ge-Sb-Te base material is being used as a material for use in phase change recording; that is, as a medium for recording information by using phase transformation.

As a method of forming this thin film formed from the Ge-Sb-Te base alloy material, it is standard to use a means generally referred to as a physical vapor deposition method such as the vacuum deposition method or the sputtering method. In particular, the thin film is often formed using the magnetron sputtering method from the perspective of operability and film stability.

Formation of films by way of the sputtering method is performed by physically colliding positive ions such as Ar ions to a target disposed on a cathode, using that collision energy to discharge materials configuring the target, and laminating a film having roughly the same composition as the target material on the opposite anode-side substrate.

The coating method based on the sputtering method is characterized in that it is possible to form films of various thicknesses; for instance, from a thin film of angstrom units to a thick film of several ten $\mu$m, with a stable deposition speed by adjusting the processing time, power supply and the like.

Conventionally, in order to inhibit the generation of particles that occurs during the sputtering process, a high density sintered compact having a relative density of approximately 98.8% was prepared by sintering, via hot press, raw material powder having high purity and a prescribed grain size.

A sintered compact that is sintered by combining a chalcogenide element (S, Se, Te), a Vb group element (Bi, Sb, As, P, N), and additionally a IVb group element (Pb, Sn, Ge, Si, C) and an additive element (Ag, Au, Pd, Pt, B, Al, Ga, In, Ti, Zr) generally has low thermal conductivity.

If there are minute defects (micropores; gaps of less than 1 $\mu$m that appear at the grain boundary portion) in this kind of sintered compact having low thermal conductivity, since the dispersion of heat is inhibited by the defects, heat will remain at the periphery thereof, and components (for instance, $GeTe_2$) having high vapor pressure will be volatilized from such portion.

Meanwhile, the remaining portion will take on a crater shape and become an abnormally eroded portion. The surface structure of a target having the foregoing defects will become the source of causing grain dropping or generating nodules, and additionally cause a major problem in that particles are generated easily.

As conventional technology, there is a method of producing a sputtering target of phase-change ZnS and $SiO_2$ having a relative density of 98% or higher by using HIP (hot isostatic pressing) and performing the treatment at a temperature of 1000°C or higher and a pressure of 100 MPa or more (refer to Patent Document 1).

Nevertheless, in the foregoing case, if only the HIP process of pressurizing the product using high-pressure Ar gas is performed, since there will always be gas at the periphery thereof, there is a drawback in that it is not possible to obtain a dense sintered compact that can be obtained with the vacuum hot press method of advancing the sintering process while eliminating the gas that is generated from the product.

[Patent Document 1] Japanese Published Unexamined Application No. 2000-26960

EP-A-1840240 describes an SbTe alloy powder for sintering to manufacture a sputtering target for forming a phase-change recording layer.

The present invention seeks to provide an improved sintered compact target and an improved method of producing a sintered compact target.

According to one aspect of the present invention, there is provided a sintered compact target as defined in claim 1 hereinafter.

According to another aspect of the present invention, there is provided a method of producing a sintered compact as defined in claim 4 hereinafter.

An embodiment of the present invention seeks to provide a sintered compact target capable of reducing minute defects within the sintered compact and having high deflecting strength, and containing a Vb group element (A) and a chalcogenide element (B) or containing the elements (A) and (B) and additionally a IVb group element (C) and/or an additive element (D), and a method of producing such a sintered compact target, and additionally provides technology that is able to eliminate the source of grain dropping or generation of nodules in the target during sputtering, and additionally inhibit the generation of particles.

This is groundbreaking technology of being able to form a low-oxygen sintered compact while initially eliminating unnecessary gas components based on vacuum hot press from the Sb-Te alloy such as GST in which pores caused by insufficient sintering due to the oxidation of the powder surface are easily formed, and further completely crushing and eliminating the remaining minute pores.

An embodiment of the present invention can be applied to both pulverized powder having an average grain size of approximately 30 $\mu$m and fine powder having an average grain size of less than 3 $\mu$m. In addition, al-

though there are cases where the grains mutually become cross-linked due to necking during hydrogen reduction, and the gaps thereof remain as pores, if the present technology is employed, the foregoing pores can also be eliminated completely, and it is also possible to produce a low-oxygen product.

In addition, it is possible to produce a high density, high strength and large diameter sintered compact target, and the present invention provides a sintered compact containing a chalcogenide element (A) and a Vb group element (B) or containing the element (A) and (B) and additionally a IVb group element (C) and/or an additive element (D) which is free from cracks even when it is assembled and used as a sputtering target-backing plate assembly, as well as a method of producing such a sintered compact.

As a result of devising the sintering conditions, the present inventors discovered that the foregoing problems can be solved.

The present invention further provides:

A method of producing a sintered compact containing an element of (A) and an element of (B) below, including the steps of mixing raw material powder composed of the respective elements or raw material powder of an alloy of two or more elements, and vacuum hot press the mixed powder under conditions that satisfy the following formula: P (pressure) $\leq \{Pf/(Tf - T_0)\} \times (T - T_0) + P_0$, (Pf: final pressure, $P_0$: atmospheric pressure, Tf: final temperature, T: heating temperature, $T_0$: room temperature, temperatures are expressed in degrees Celsius)), and further performing HIP treatment under the conditions of $P_{hip} > 5 \times Pf$, wherein the sintered compact is free from pores having an average diameter of 1 $\mu$m or more, and the number of micropores having an average diameter of less than 1 $\mu$m existing in an area of 40000 $\mu m^2$ of the target surface is 100 micropores or less:

(A): one or more chalcogenide elements selected from S, Se, and Te; and
(B): one or more Vb group elements selected from Bi, Sb, As, P, and N.

A method of producing a sintered compact containing an element of (A) and an element of (B) below as well as one or more elements selected from (C) or (D) below, including the steps of mixing raw material powder composed of the respective elements or raw material powder of an alloy of two or more elements, and vacuum hot press the mixed powder under conditions that satisfy the following formula: P (pressure) $\leq \{Pf/(Tf - T_0)\} \times (T - T_0) + P_0$, (Pf: final pressure, $P_0$: atmospheric pressure, Tf: final temperature, T: heating temperature, $T_0$: room temperature, temperatures are expressed in degrees Celsius)), and further performing HIP treatment under the con-

ditions of $P_{hip} > 5 \times Pf$, wherein the sintered compact is free from pores having an average diameter of 1 $\mu$m or more, and the number of micropores having an average diameter of 0.1 to 1 $\mu$m existing in an area of 40000 $\mu m^2$ of the target surface is 100 micropores or less:

(A): one or more chalcogenide elements selected from S, Se, and Te;
(B): one or more Vb group elements selected from Bi, Sb, As, P, and N;
(C): one or more IVb group elements selected from Pb, Sn, Ge, Si, and C; and
(D): one or more elements selected from Ag, Au, Pd, Pt, B, Al, Ga, In, Ti, and Zr.

The present invention also provides:

The method of producing a sintered compact according to paragraph 7 or

Conventionally, when producing a sintered compact target using raw material powder containing a chalcogenide element (A) and a Vb group element (B) or raw material powder additionally containing a IVb group element (C) or an intended additive element (D), numerous defects of micropores would exist and become the source of grain dropping and nodules, and this is a major cause of the generation of particles during sputtering deposition. The inventors discovered that defects of micropores and the like are a major cause of the generation of particles, and offers a method of considerably reducing the defects of such micropores from the sintered compact target.

Since the sintered compact having the composition of an embodiment of the present invention is extremely fragile, if a large diameter sputtering target is prepared and this is bonded with a backing plate, there was a problem in that cracks would occur on the target surface or the target itself would crack due to the difference in thermal expansion. Nevertheless, an embodiment of the present invention is able to produce a high strength, high density and large diameter sintered compact or sputtering target capable of considerably reducing defects such as micropores by improving the production process.

An embodiment of the present invention seeks to yield a superior effect of being able to prevent the generation of cracks and the like even when the target is bonded to a backing plate, and also keep the warping to be within a tolerable range.

[Brief Description of the Drawings]

[Fig. 1] A 5000x microphotograph upon observing the target structure of Example 1.
[Fig. 2] A 5000x microphotograph upon observing the target structure of Example 2.
[Fig. 3] A 5000x microphotograph upon observing the target structure of Comparative Example 1.
[Fig. 4] A 5000x microphotograph upon observing the target structure of Comparative Example 5.

(Sintering raw material and control of pressure rise and temperature rise conditions of hot press)

As described above, upon producing a sintered compact, the following steps are performed; namely, mixing raw material powder composed of the respective elements or raw material powder of an alloy of two or more elements, and vacuum hot pressing the mixed powder under conditions that satisfy the following formula: P (pressure) $\leq \{Pf/(Tf - T_0)\} \times (T - T_0) + P_0$ (Pf: final pressure, Tf: final temperature, $P_0$: atmospheric pressure, T: heating temperature, $T_0$: room temperature (temperatures are expressed in degrees Celsius)):

    (A): one or more chalcogenide elements selected from S, Se, and Te
    (B): one or more Vb group elements selected from Bi, Sb, As, P, and N

In addition, as necessary, the following element of (C) or element of (D) is added.

    (C): one or more IVb group elements selected from Pb, Sn, Ge, Si, and C
    (D): one or more elements selected from Ag, Au, Pd, Pt, B, Al, Ga, In, Ti, and Zr

Consequently, produced is a sintered compact containing a chalcogenide element (A) and a Vb group element (B), or a sintered compact containing a chalcogenide element (A) and a Vb group element (B) as well as a IVb group element (C) or an intended additive element (D).

Controlling the pressure rise and temperature rise conditions of the hot press in a vacuum as described above is an important and basic process, and is achieved by relatively and gradually increasing the pressure P in relation to the temperature T during the course of the temperature rise.

When deviating from these conditions, it becomes difficult to effectively inhibit the generation of defects such as micropores, and it is also virtually impossible to product a large diameter sintered compact or sputtering target having high strength and high density.

With the foregoing vacuum hot press, the material of an embodiment of the present invention which is easily oxidized can be sintered in a low-oxygen state. In addition, it is also possible to simultaneously prevent the inclusion of unwanted gas components.

The sintered compact target obtained based on the production method of an embodiment of the present invention is able to considerably reduce the defects of micropores and the like. In addition, a large diameter sputtering target having a mechanically high strength is able to inhibit and improve the particle generation rate of a conventional target having a diameter of approximately 300 mm. This is because the grain boundary of the sintered compact has been strengthened based on the fine uniform crystal structure that is free from pores. This can only be achieved based on the foregoing condition of an embodiment of the present invention.

One of the essential basic conditions for achieving an embodiment of the present invention is to perform hot pressing under conditions that satisfy P (pressure) $\leq \{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), but it is effect to stabilize the pressure for 10 to 120 minutes during the course of the temperature T rising from 100 to 500°C.

By devising the sintering conditions; that is, by combining hot press and HIP, it is possible to produce a low-oxygen, high density sintered compact that is free from micropores.

HIP is performed under the same achieving temperature condition as the hot press, and under the condition of $P_{HIP} > 5 \times Pf$. HIP is able to completely eliminate the micropores that are remaining internally. The HIP treatment is an important requirement for achieving the number of micropores having an average diameter of 0.1 to 1 $\mu$m existing in an area of 40000 $\mu$m$^2$ on the target surface to be 10 micropores or less, and even 1 micropore or less.

Further, it is desirable to keep the content of oxygen as an impurity to be 2000 ppm or less. The inclusion of gas components in excess of the foregoing value will cause the generation of a nonconductor such as oxides. Thus, the reduction of oxygen will prevent arcing and thereby inhibit the generation of particles caused by the arcing. Although this is not a special condition in an embodiment of the present invention, it is a preferable condition.

The Sb-Te-based alloy sintered compact sputtering target of an embodiment of the present invention may contain, at maximum 20 at%, one or more elements selected from Ag, Au, Pd, Pt, B, Al, Ga, In, Ti, and Zr as additive elements. So as long as the amount is within the foregoing range, in addition to obtaining the intended glass transition temperature, transformation rate and electrical resistance value, it is also possible to minimize the surface defects resulting from the machining process, and the particles can also be effectively inhibited.

Based on the above, it is possible to obtain a sintered compact having a diameter of 380 mm or more and a thickness of 20 mm or less containing a chalcogenide element (A) and a Vb group element (B) and, as needed, additionally containing a IVb group element (C) and/or additive element (D).

Consequently, it is possible to obtain a sintered compact composed of a chalcogenide element (A) and a Vb group element (B) or a sintered compact composed of a chalcogenide element (A) and a Vb group element (B) as well as a IVb group element (C) and/or additive element (D) having a sintered structure in which the average grain size is 50 $\mu$m or less, the deflecting strength is 40 MPa or more, the relative density is 99% or higher, and the standard deviation of the in-plane density of the sintered compact surface is less than 1%.

The sputtering target produced from the sintered compact obtained as described above is able to considerably reduce defects such as micropores, is free from cracks even when it is bonded to a backing plate, and yields a superior effect of also maintaining the warping within a tolerable range.

As described above, the sintered compact sputtering target is free from defects such as micropores, and a target having a uniform fine crystal structure will have reduced surface irregularities caused by sputter erosion and yield a half-mirror appearance, is free from a crater-shaped abnormal structure, and is able to effectively inhibit the generation of particles caused by the redeposited film on the target surface peeling off. Consequently, it is possible to effectively inhibit the generation of particles, abnormal discharge, and nodules during the foregoing sputtering process.

With the sputtering target of an embodiment of the present invention, it is possible to make the content of oxygen to be 2000 ppm or less, in particular 1000 ppm or less, and even 500 ppm or less. The reduction of oxygen is effective in further reducing the generation of particles and the generation of abnormal discharge.

[Examples]

The present invention is now explained in detail with reference to the Examples. These Examples are merely illustrative, and the present invention shall in no way be limited thereby.

(Example 1)

The respective raw material powders of Te, Sb and Ge respectively having a purity of 99.995 (4N5) excluding gas components were melted to obtain a composition of $Ge_{22}Sb_{22}Te_{56}$, and slowly cooled in a furnace to prepare a cast ingot. The raw materials of the respective elements were subject to acid cleaning and deionized water cleaning prior to the melting process in order to sufficiently eliminate impurities remaining on the surface.

Consequently, a high purity $Ge_{22}Sb_{22}Te_{56}$ ingot maintaining a purity 99.995 (4N5) was obtained. Subsequently, the high purity $Ge_{22}Sb_{22}Te_{56}$ ingot was pulverized with a ball mill in an inert atmosphere to prepare raw material powder having an average grain size of approximately 30 $\mu$m, and a maximum grain size of approximately 90 $\mu$m (one figure of the grain size was rounded off).

Subsequently, the raw material powder was filled in a graphite die having a diameter of 400 mm, and subject to the following conditions in an inert atmosphere; namely, a final rise temperature of 600°C at a temperature rise rate of 5°C/min, and a final pressing pressure of 150 kgf/cm². Further, as a result of controlling the hot press pressurization pattern to satisfy, with respect to the temperature, the conditions of the following formula: $P$ (pressure) $\leq \{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), a $Ge_{22}Sb_{22}Te_{56}$ intermediate sintered compact was prepared.

In the foregoing case, for instance, based on the foregoing formula, the pressing pressure was strictly adjusted to $P \leq 20$ kgf/cm² since this will be P (kgf/cm²) $\leq \{150$ (kgf/cm²) / (600°C - 25°C)$\} \times$ (100°C - 25°C) + 1 (kgf/cm²) at a heating temperature of 100°C. Similarly, the pressing pressure was strictly adjusted to $P \leq 45$ kgf/cm² at a heating temperature of 200°C and to $P \leq 72$ kgf/cm² at a heating temperature of 300°C in order to achieve the hot press pressurization pattern according to the foregoing formula.

Specifically, the pressing pressure was set to $P = 0$ kgf/cm² when the heating temperature is less than 100°C, to the pressing pressure of $P = 20$ kgf/cm² when the heating temperature is 100 to 200°C, to the pressing pressure of $P = 45$ kgf/cm² when the heating temperature is 200 to 300°C, to the pressing pressure of $P = 72$ kgf/cm² when the heating temperature is 300 to the final rise temperature of 600°C, and to the pressing pressure of $P = 150$ kgf/cm² when the heating temperature is 600°C.

Incidentally, since the pressing pressure can be gradually increased as described above pursuant to the increase in the heating temperature, the final pressing pressure will reach 150 kgf/cm² more quickly. Thus, it can be said that the production time efficiency can be shortened and the production efficiency can be improved by just that much. Nevertheless, an absolute condition is not to deviate from the foregoing formula. Moreover, the sintered compact was retained for 2 hours after reaching the final rise temperature and the final pressing pressure.

HIP treatment was further performed to the obtained intermediate sintered compact having a diameter of 400 mm under the condition of $P_{HIP} = 750$ to 2000 kgf/cm². Specifically, HIP treatment was performed under the following five types of conditions; namely, $P_{HIP} = 750$ kgf/cm², $P_{HIP} = 900$ kgf/cm², $P_{HIP} = 1000$ kgf/cm², $P_{HIP} = 1500$ kgf/cm², and $P_{HIP} = 2000$ kgf/cm².

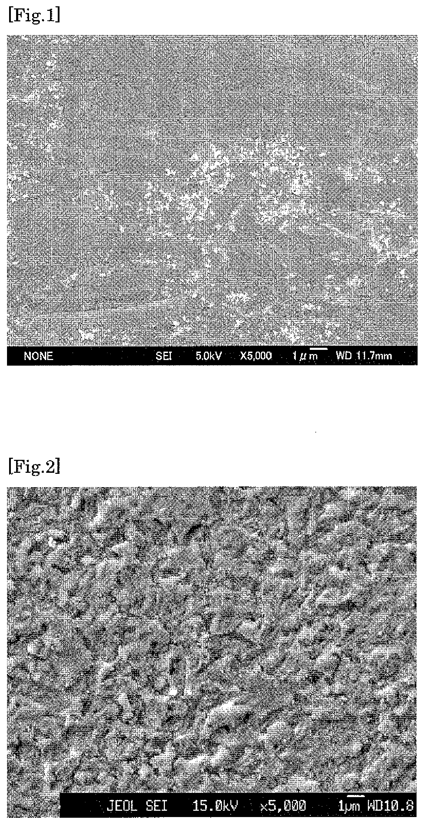

The target shown in Fig. 1 is an example of $P_{HIP} = 1000$ kgf/cm², and is the structure of a target that used standard pulverized powder, and had a crystal grain size of 30 $\mu$m or less.

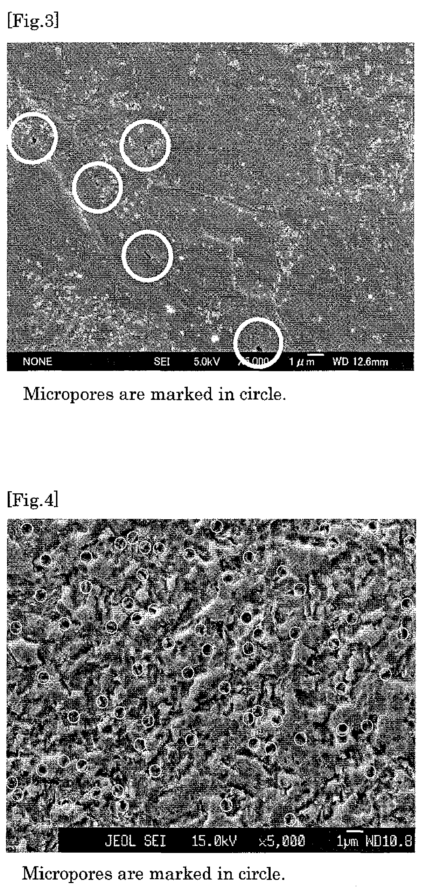

With Fig. 3 corresponding to Comparative Example 1 described later, at the hot press stage, 5 micropores (micropores having an average diameter of 0.1 to 1 $\mu$m) were observed at the grain boundary. This corresponds to approximately 500 micropores in an area of

40000 μm$^2$.

Subsequently, the obtained final sintered compact was subject to cutting work in order to prepare a target. Based on the foregoing HIP treatment, nearly all of the micropores were eliminated. The results are shown in Fig. 1. This is a 5000x microphotograph upon observing the structure of the target.

Specifically, as shown in Fig. 1, the number of micropores having an average diameter of less than 1 μm existing in an area of 40000 μm$^2$ on the target surface was 0 micropores. Pores having an average diameter of 1 μm or more also did not exist at all.

Although this result is based on a representative example of performing the HIP treatment at P$_{HIP}$ = 1000 kgf/cm$^2$, even with the targets that were subject to the HIP treatment based on the other four conditions, the number of micropores having an average diameter of less than 1 μm existing in an area of 40000 μm$^2$ on the target surface was also 0 micropores. Pores having an average diameter of 1 μm or more also did not exist at all.

As described above, it was discovered that the two-stage sintering for which appropriate conditions were set is extremely effective in eliminating the micropores.

Moreover, in order to measure the density, the measurement was performed upon sampling from 9 locations in a cross shape. This average value was defined as the sintered compact density. The average value of the deflecting strength was measured by sampling from the middle of the center and the radial direction, and three locations in the peripheral vicinity, and this average value was defined as the deflecting strength.

The average grain size of the sintered compact was calculated from the result of observing the structure of 9 locations in a cross shape. Consequently, in Example 1, the relative density of the sintered compact was 99.8%, the standard deviation of the variation in the density was < 1%, the deflecting strength was 61 MPa, and, with respect to the composition of the respective crystal grains, Ge was within the range of 17.8 to 26.6 at% and Sb was within the range of 17.8 to 26.6 at% (± 20%), the average grain size of the sintered compact was 36 μm and the maximum grain size was 90 μm, and a favorable sintered compact was obtained.

Using similar methods, favorable bonding properties have been confirmed regardless of the type of backing plate; regardless of whether they are formed from copper alloy or aluminum alloy.

Subsequently, the target surface was observed, but no macro pattern could be found across the entire target.

Sputtering was performed using this target, and this target had an extremely low particle generation rate of 18 particles or less in comparison to a conventional high quality, high density small-sized target (diameter 280 mm). In addition, there was no occurrence of grain dropping or generation of nodules caused by micropores during sputtering.

(Example 2)

In addition to the conditions of Example 1, additional pulverization was performed using a jet mill. The sintering conditions using this powder; that is, the sintering conditions of the vacuum hot press and HIP were the same as Example 1. The structure of the target using the jet mill powder is shown in Fig. 2.

As shown in Fig. 2, as with Example 1, micropores having an average diameter of less than 1 μm existing in an area of 40000 μm$^2$ on the target surface could not be acknowledged at all.

It was possible to obtain a sintered compact having composition uniformity in which Ge is within the range 21.1 to 23.3 at% and Sb is within the range of 21.1 to 23.3 at% (± 5%), average crystal grain size was 2.2 μm and maximum grain size was 8 μm yielding an ultrafine structure, oxygen concentration was 1900 ppm, relative density was 99.8%, standard deviation in the variation of the density was < 1%, and deflecting strength was 90 MPa.

(Example 3)

Ag, In, Sb, Te powder raw materials respectively having a purity of 4N5 excluding gas components were used and blended to achieve a Ag$_5$In$_5$Sb$_{70}$Te$_{20}$ alloy, and, under the same sintering conditions as Example 1; that is, based on vacuum hot press and HIP, a sintered compact having a purity of 4N5 and a composition of Ag$_5$In$_5$Sb$_{70}$Te$_{20}$ was obtained. Specifically, excluding the component composition, a sintered compact was prepared to coincide with the conditions of Example 1.

Micropores were examined in the sintered compact having a diameter of 400 mm that was prepared in Example 3. Consequently, nearly all of the micropores were eliminated. After HIP, the number of micropores having an average diameter of less than 1 μm existing in an area of 40000 μm$^2$ on the target surface was also 0 micropores. Moreover, pores having an average diameter of 1 μm or more also did not exist at all. As described above, it was discovered that the two-stage sintering for which appropriate conditions were set is extremely effective in eliminating the micropores.

Moreover, in order to measure the density, the measurement was performed upon sampling from 9 locations in a cross shape. This average value was defined as the sintered compact density. The average value of the deflecting strength was measured by sampling from the middle of the center and the radial direction, and three locations in the peripheral vicinity, and this average value was defined as the deflecting strength. The average grain size of the sintered compact was calculated from the result of observing the structure of 9 locations in a cross shape.

Consequently, in Example 3, the relative density of the sintered compact was 99.8%, the standard deviation of the variation in the density was < 1%, the deflecting strength was 51 MPa, and the average grain size of the sintered compact was 38 $\mu$m, and a favorable sintered compact was obtained. In addition, there was no occurrence of grain dropping or generation of nodules caused by micropores during sputtering.

Although not shown in the Examples, the sintered compacts and the targets produced therefrom containing other chalcogenide elements (A) and Vb group elements (B) as well as other IVb group elements (C) or additive elements (D) were all favorable sintered compacts as with Example 1 and Example 2 in which the relative density of the sintered compact was 99.8% or higher, standard deviation in the variation of the density was < 1 %, deflecting strength was 60 MPa or more, and average grain size of the sintered compact was 36 $\mu$m or less.

Moreover, warping after the bonding could not be acknowledged at all, and there were no cracks after the bonding. In addition, the macro pattern was observed during the polishing process, but no macro pattern could be found across the entire target. Sputtering was performed using this target, and this target showed a particle generation rate that is equal to or less than a conventional high quality, high density small-sized target (diameter 280 mm).

(Comparative Example 1)

The respective raw material powders of Te, Sb and Ge respectively having a purity of 99.995 (4N5) excluding gas components were melted to obtain a composition of $Ge_{22}Sb_{22}Te_{56}$, and prepare a cast ingot. The raw materials of the respective elements were subject to acid cleaning and deionized water cleaning prior to the melting process in order to sufficiently eliminate impurities remaining on the surface.

Consequently, a high purity $Ge_{22}Sb_{22}Te_{56}$ ingot maintaining a purity 99.995 (4N5) was obtained. Subsequently, the high purity $Ge_{22}Sb_{22}Te_{56}$ ingot was pulverized with a ball mill in an inert atmosphere to prepare raw material powder having an average grain size of approximately 30 $\mu$m, and a maximum grain size of approximately 90 $\mu$m (one figure of the grain size was rounded off). The foregoing conditions are the same as Example 1.

Subsequently, the raw material powder was filled in a graphite die having a diameter of 400 mm, and subject to the following conditions in an inert atmosphere; namely, a final rise temperature of 600°C at a temperature rise rate of 15°C/min, and a final pressing pressure of 150 kgf/cm$^2$. Further, as a result of controlling the hot press pressurization pattern to satisfy, with respect to the temperature, the conditions of the following formula: P (pressure $\{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), a $Ge_{22}Sb_{22}Te_{56}$ sintered compact was prepared. HIP was not performed. The structure of the target prepared based on the foregoing conditions is shown in Fig. 3. As shown in Fig. 3, micropores can be observed at the crystal grain boundary.

(Comparative Example 2)

The raw material powder obtained in Comparative Example 1 was filled in a graphite die having a diameter of 400 mm, and subject to the following conditions in an inert atmosphere; namely, a final rise temperature of 450°C at a temperature rise rate of 5°C/min, and a final pressing pressure of 150 kgf/cm$^2$. Further, as a result of controlling the hot press pressurization pattern to satisfy, with respect to the temperature, the conditions of the following formula: P (pressure $\{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), a $Ge_{22}Sb_{22}Te_{56}$ sintered compact was prepared. HIP was not performed.

(Comparative Example 3)

The raw material powder obtained in Comparative Example 1 was filled in a graphite die having a diameter of 400 mm, and subject to the following conditions in an inert atmosphere; namely, a final rise temperature of 600°C at a temperature rise rate of 5°C/min, and a final pressing pressure of 80 kgf/cm$^2$. Further, as a result of controlling the hot press pressurization pattern to satisfy, with respect to the temperature, the conditions of the following formula: P (pressure $\{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), a sintered compact was prepared. HIP was not performed.

(Comparative Example 4)

The raw material powder obtained in Comparative Example 1 was filled in a graphite die having a diameter of 400 mm, and subject to the following conditions in an inert atmosphere; namely, a final rise temperature of fi00°C at a temperature rise rate of 5°Clrnin, and a final pressing pressure of 150 kgf/cm$^2$. Further, as a result of controlling the hot press pressurization pattern outside the conditions of the following formula: P (pressure) $\leq \{Pf/(Tf - T_0)\} \times (T - T_0) + P_0$, (Pf: final pressure, Tf: final temperature, $P_0$: atmospheric pressure, T: heating temperature, $T_0$: room temperature, temperatures are expressed in degrees Celsius), a sintered compact was prepared.

As the condition outside the foregoing formula, the pressing pressure was raised to P = 75 kgf/cm$^2$ at the stage when the heating temperature was 100°C in order to accelerate the pressurization process. HIP was not performed.

As described above, with the conditions of an embodiment of the present invention, based on the foregoing formula, the pressing pressure was strictly adjusted to P ≤ 20 kgf/cm$^2$ since this will be P ≤ 150 (kgf/cm$^2$)/600°C × 100°C at a heating temperature of 100°C. Similarly, the pressing pressure was strictly adjusted to P ≤ 45 kgf/cm$^2$ at a heating temperature of 200°C and to P ≤ 72 kgf/cm$^2$ at a heating temperature of 300°C in order to achieve the hot press pressurization pattern according to the foregoing formula. However, the condition of accelerating the pressurization process by raising the pressing pressure to P = 72 kgf/cm$^2$ deviates from the conditions of an embodiment of the present invention. In addition, this production method clearly differs from an embodiment of the present invention with respect to the point that HIP was not performed.

(Comparative Example 5)

In addition to the conditions of Example 1, additional pulverization was performed using a jet mill. The sintering conditions using this powder; that is, the sintering conditions of the vacuum hot press and HIP were the same as Example 1. Nevertheless, the sintered compact was produced without performing HIP, and the conditions are for comparison with Example 2. The composition was as follows; namely, Ge was within the range of 21.1 to 23.3 at%, and Sb was within the range of 21.1 to 23.3 at% (± 5%).

With the obtained sintered compact, the average crystal grain size was 2.2 μm, maximum grain size was 8 μm, oxygen concentration was 1900 ppm, relative density of the sintered compact was 99.8%, standard deviation in the variation of the density was < 1%, and deflecting strength was 75 MPa.

The structure of the target prepared with this production method is shown in Fig. 4. As shown in Fig. 4, numerous micropores were observed.

In order to measure the density of the sintered compact having a diameter of 400 mm obtained in Comparative Examples 1 to 5, the measurement was performed upon sampling from 9 locations in a cross shape. This average value was defined as the sintered compact density. The average value of the deflecting strength was measured by sampling from the middle of the center and the radial direction, and three locations in the peripheral vicinity, and this average value was defined as the deflecting strength. The average grain size of the sintered compact was calculated from the result of observing the structure of 9 locations in a cross shape. These measurement conditions are the same as Example 1.

Consequently, in Comparative Example 1, the relative density of the sintered compact was 98.5%, the standard deviation of the variation in the density was 3%, the deflecting strength was 32 MPa, and the average grain size of the sintered compact was 42 μm, and a fragile sintered compact was obtained. The number of micropores having an average diameter of less than 1 μm existing in an area of 40000 μm$^2$ on the target surface was numerous at 500 micropores.

Similarly, in Comparative Example 2, the relative density of the sintered compact was 94%, the standard deviation of the variation in the density was 1%, the deflecting strength was 26 MPa, and the average grain size of the sintered compact was 35 μm, and a fragile sintered compact was obtained. The number of micropores having an average diameter of less than 1 μm existing in an area of 40000 μm$^2$ on the target surface was numerous at 1000 micropores.

Similarly, in Comparative Example 3, the relative density of the sintered compact was 96.1%, the standard deviation of the variation in the density was 1%, the deflecting strength was 29 MPa, and the average grain size of the sintered compact was 39 μm, and a fragile sintered compact was obtained. The number of micropores having an average diameter of less than 1 μm existing in an area of 40000 μm$^2$ on the target surface was numerous at 1500 micropores.

Similarly, in Comparative Example 4, the relative density of the sintered compact was 99.2%, the standard deviation of the variation in the density was 1%, the deflecting strength was 39 MPa, and the average grain size of the sintered compact was 42 μm, and a fragile sintered compact was obtained. The number of micropores having an average diameter of less than 1 μm existing in an area of 40000 μm$^2$ on the target surface was numerous at 1200 micropores.

Similarly, in Comparative Example 5, the relative density of the sintered compact was 99.2%, the standard deviation of the variation in the density was 1%, the deflecting strength was 75 MPa, and the average grain size of the sintered compact was 42 μm, and a fragile sintered compact was obtained in comparison to Example 2. The number of micropores having an average diameter of less than 1 μm existing in an area of 40000 μm$^2$ on the target surface was numerous at 7000 micropores.

The sintered compacts prepared in Comparative Example 1 to 5 were respectively bonded to a copper alloy backing plate using indium so that the bonding thickness would become 0.4 to 1.4 mm according to the same process as Example 1. Subsequently, a target plate was prepared by performing cutting work.

Consequently, warping occurred after bonding, and some cracks were observed after the bonding, and a macro pattern was observed at various parts of the target.

Sputtering was performed using this target, but the particle generation rate was significantly high at 300 to several thousand particles, and was far lower than a practically applicable level.

The inventors discovered that defects of micropores and the like are a major cause of the generation of particles, and offers a method of considerably reducing the defects of such micropores from the sintered compact target. An embodiment of the present invention is able to significantly reduce defects of micropores and the like by improving the production process.

Since the sintered compact having the composition of an embodiment the present invention is extremely fragile, if a large diameter sputtering target is prepared and this is bonded with a backing plate, there was a problem in that cracks would occur on the target surface or the target itself would crack due to the difference in thermal expansion. Nevertheless, an embodiment of the present invention is able to produce a high strength, high density and large diameter sintered compact or sputtering target.

Accordingly, upon forming a thin film of a Ge-Sb-Te material or the like as a phase change recording material; that is, as a medium for recording information by using phase transformation, it will be possible to use a larger sputtering target and improve the quality of deposition, and an embodiment of the present mvention yields superior effects of being able to improve the production efficiency, and produce a uniform phase change recording material.

## Claims

1. A sintered compact target consisting of an alloy of Sb and Te and, at maximum 20 at%, one or more elements selected from group consisting of Ag, Au, Pd, Pt, B, Al, Ga, In, Ti, and Zr, **characterised in that** the diameter of the sintered compact target is 380mm or more, the sintered compact target is free from pores having an average diameter of 1 $\mu$m or more, and the number of micropores having an average diameter of less than 1 $\mu$m existing in an area of 40000 $\mu$m$^2$ of the target surface is 100 micropores or less.

2. The sintered compact target according to any one of claim 1,
   wherein the sintered compact target structure has an average crystal grain size of 50 $\mu$m or less, a deflection strength of 40 MPa or more, a relative density is 99% or higher, a standard deviation of the relative density of less than 1%, and differences in the compositions of respective crystal grains configuring the sintered compact target of less than $\pm$ 20% of the overall average composition of the sintered compact target.

3. The sintered compact target according to claim 2, wherein the average crystal grain size is 10 $\mu$m or less.

4. A method of producing a sintered compact, the method comprising the steps of mixing raw material powders of constituent elements or a raw material powder of an alloy of two or more elements, the purity of the raw material powder being 4N5, hot pressing under a vacuum the mixed powder under varying temperature-pressure conditions that satisfy the formula:

$$P \leq \{Pf/(Tf - T_0)\} \times (T - T_0) + P_0,$$

where P is the pressure, Pf the final achieving pressure, $P_0$ the atmospheric pressure, T the heating temperature, Tf the final achieving heating temperature and $T_0$ the room temperature, and performing HIP treatment to a mass resulting from the hot-pressing, the HIP treatment being performed at a pressure $P_{hip}$ which is greater than 5 $\times$ Pf and at a temperature $T_{hip}$ which is equal to Tf, to obtain a sintered compact consisting of an alloy of Sb and Te and, at maximum 20 at%, one or more elements selected from group consisting of Ag, Au, Pd, Pt, B, Al, Ga, In, Ti, and Zr and having a structure that is free from pores having an average diameter of 1 $\mu$m or more, and containing micropores having an average diameter of less than 1 $\mu$m in a number of 100 or less over an area of 40000 $\mu$m$^2$ of a surface of the sintered compact target.

5. The method of producing a sintered compact according to claim 4, wherein the raw material powders have an average grain size is 0.1 $\mu$m to 50 $\mu$m, the maximum grain size of 90 $\mu$m or less, and a purity of 4N or higher.

6. The method of producing a sintered compact according to claim 4 or claim 5, wherein, during the hot pressing step, the heating temperature T is raised from 100 to 500°C during the hot press and, through at least part of the heating temperature range, the pressure is maintained at a constant level for 10 to 120 minutes.

## Patentansprüche

1. Gesintertes kompaktes Target bestehend aus einer Legierung von Sb und Te und, bei maximal 20 at%, einem oder mehreren Elementen ausgewählt aus der Gruppe bestehend aus Ag, Au, Pd, Pt, B, Al, Ga, In, Ti und Zr, **dadurch gekennzeichnet, dass** der Durchmesser des gesinterten kompakten Targets 380 mm oder mehr beträgt, wobei das gesinterte kompakte Target frei von Poren mit einem durchschnittlichen Durchmesser von 1 $\mu$m oder mehr ist und die Anzahl Mikroporen mit einem durchschnittlichen Durchmesser von weniger als 1 $\mu$m, die in einem Bereich von 40000 $\mu$m$^2$ der Targetoberfläche existieren, 100 Mikroporen oder weniger beträgt.

2. Gesintertes kompaktes Target nach Anspruch 1, worin das Gefüge des gesinterten kompakten Targets eine durchschnittliche Kristallkorngröße von 50 $\mu$m oder weniger, eine Durchbiegungsfestigkeit von 40 MPa oder mehr, eine relative Dichte von 99 % oder höher, eine Standardabweichung der relativen Dichte von weniger als 1 % und Unterschiede bei den Zusammensetzungen von jeweiligen Kristallkörnern, die das gesinterte kompakte Target konfigurieren, von weniger als $\pm$ 20 % der insgesamten durchschnittlichen Zusammensetzung des gesinterten kompakten Targets aufweist.

3. Gesintertes kompaktes Target nach Anspruch 2, worin die durchschnittliche Kristallkorngröße 10 $\mu$m oder weniger beträgt.

4. Verfahren zur Herstellung eines gesinterten Kompakts, wobei das Verfahren die Schritte des Mischens von Rohstoffpulvern von Elementarbestandteilen oder eines Rohstoffpulvers einer Legierung von zwei oder mehr Elementen, wobei die Reinheit des Rohstoffpulvers 4N5 lautet, des Heißpressens, unter einem Vakuum, des gemischten Pulvers unter verschiedenen Temperatur-Druck-Bedingungen, die die Formel

$$P \leq \{Pf/(Tf\text{-}T_0)\} \times (T\text{-}T_0) + P_0$$

erfüllen, wobei P der Druck, Pf der zu erzielende Enddruck, $P_0$ der atmosphärische Druck, T die Erhitzungstemperatur, Tf die zu erzielende Enderhitzungstemperatur und $T_0$ die Raumtemperatur ist, und des Durchführens einer HIP-Behandlung einer aus dem Heißpressen resultierenden Masse umfasst, wobei die HIP-Behandlung bei einem Druck $P_{hip}$, der größer als 5 x Pf ist, und bei einer Temperatur $T_{hip}$, die gleich Tf ist, durchgeführt wird, um ein gesintertes Kompakt zu erhalten, das aus einer Legierung von Sb und Te und, bei maximal 20 at%, einem oder mehreren Elementen ausgewählt aus der Gruppe bestehend aus Ag, Au, Pd, Pt, B, Al, Ga, In, Ti und Zr besteht und eine Struktur aufweist, die frei von Poren mit einem durchschnittlichen Durchmesser von 1 $\mu$m oder mehr ist und Mikroporen mit einem durchschnittlichen Durchmesser von weniger als 1 $\mu$m in einer Anzahl von 100 oder weniger über einen Bereich von 40000 $\mu$m$^2$ einer Oberfläche des gesinterten kompakten Targets enthält.

5. Verfahren zur Herstellung eines gesinterten Kompakts nach Anspruch 4, worin die Rohstoffpulver eine durchschnittliche Korngröße von 0,1 $\mu$m bis 50 $\mu$m, eine maximale Korngröße von 90 $\mu$m oder weniger und eine Reinheit von 4N oder höher aufweisen.

6. Verfahren zur Herstellung eines gesinterten Kompakts nach Anspruch 4 oder Anspruch 5, worin, während des Heißpressschritts, die Erhitzungstemperatur T von 100 auf 500 °C während des Heißpressens erhöht und, über zumindest einen Teil des Erhitzungstemperaturbereichs, der Druck 10 bis 120 Minuten lang auf einem konstanten Niveau gehalten wird.

## Revendications

1. Cible de corps fritté consistant en un alliage de Sb, Te et, à un maximum de 20 % en atomes, d'un ou plusieurs éléments choisis dans le groupe constitué de Ag, Au, Pd, Pt, B, Al, Ga, In, Ti et Zr, la cible de corps fritté étant **caractérisée en ce que** son diamètre est supérieur ou égal à 380 mm, la cible de corps fritté étant exempte de pores ayant un diamètre moyen supérieur ou égal à 1 $\mu$m, et le nombre de micropores ayant un diamètre moyen inférieur à 1 $\mu$m présents dans une aire de 40 000 $\mu$m$^2$ de la surface cible est inférieur ou égal à 100 micropores.

2. Cible de corps fritté selon la revendication 1, dont la structure a une taille moyenne des grains de cristal inférieure ou égale à 50 $\mu$m, une résistance à la flexion supérieure ou égale à 40 MPa, une densité relative supérieure ou égale à 99 %, un écart-type de la densité relative inférieur à 1 %, et des différences dans les compositions des grains de cristal respectifs configurant la cible de corps fritté inférieures à $\pm$ 20 % de la composition moyenne globale de la cible de corps fritté.

3. Cible de corps fritté selon la revendication 2, dans laquelle la taille moyenne des grains de cristal est inférieure ou égale à 10 $\mu$m.

4. Procédé de production d'un corps fritté, le procédé comprenant les étapes consistant à mélanger des poudres de matière première d'éléments constituants ou une poudre de matière première d'un alliage d'au moins deux éléments, la pureté de la poudre de matière première étant égale à 4N5, presser à chaud sous vide la poudre mélangée dans des conditions de température-pression variables qui satisfont à la formule :

$$P \leq \{Pf/(Tf - T_0)\} \times (T - T_0) + P_0,$$

où P est la pression, Pf la pression obtenue finale, $P_0$ la pression atmosphérique, T la température de chauffage, Tf la température de chauffage obtenue finale et $T_0$ la température ambiante, et soumettre une masse résultant du pressage à chaud à un traitement de pressage isostatique à chaud (HIP), le traitement HIP étant réalisé à une pression $P_{hip}$ supérieure à 5 x Pf et à une température $T_{hip}$ égale à Tf, afin d'obtenir un corps fritté constitué d'un alliage de Sb, Te et, à un maximum de 20 % en atomes, d'un ou plusieurs éléments choisis dans le groupe constitué de Ag, Au, Pd, Pt, B, Al, Ga, In, Ti et Zr, et ayant une structure exempte de pores ayant un diamètre moyen supérieur ou égal à 1 $\mu$m, et comportant un nombre inférieur ou égal à 100 de micropores ayant un diamètre moyen inférieur à 1 $\mu$m dans une aire de 40 000 $\mu$m$^2$ d'une surface de la cible de corps fritté.

5. Procédé de production d'un corps fritté selon la revendication 4, dans lequel les poudres de matière première ont une grosseur moyenne des grains comprise entre 0,1 $\mu$m et 50 $\mu$m, la grosseur maximale des grains étant inférieure ou égale à 90 $\mu$m, et une pureté supérieure ou égale à 4N.

6. Procédé de production d'un corps fritté selon la revendication 4 ou 5, dans lequel pendant l'étape de pressage à chaud, la température de chauffage T est augmentée de 100 à 500 °C pendant le pressage à chaud et, sur au moins une partie de la plage de température de chauffage, la pression est maintenue à un niveau constant pendant 10 à 120 minutes.

[Fig.1]

NONE      SEI   5.0kV   X5,000   1 μm   WD 11.7mm

[Fig.2]

JEOL SEI   15.0kV   x5,000   1μm WD10.8

[Fig.3]

Micropores are marked in circle.

[Fig.4]

Micropores are marked in circle.

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000026960 A

- EP 1840240 A